# EUROPEAN PATENT SPECIFICATION

(11) **EP 4 049 083 B1**
(45) Date of publication and mention of the grant of the patent: **04.09.2024**
(21) Application number: 20803445.4
(22) Date of filing: 16.10.2020
(51) Int. Cl.: G02F 1/017, H01S 5/34, B82Y 20/00, H01S 5/343, H01S 5/026

(54) **SEMICONDUCTOR STRUCTURE AND FABRICATION OF A SEMICONDUCTOR STRUCTURE WITH MULTIPLE QUANTUM WELLS**
HALBLEITERSTRUKTUR UND HERSTELLUNG EINER HALBLEITERSTRUKTUR MIT MEHREREN QUANTENTÖPFEN
STRUCTURE SEMI-CONDUCTRICE ET FABRICATION D'UNE STRUCTURE SEMI-CONDUCTRICE DOTÉE DE MULTIPLES PUITS QUANTIQUES

(30) Priority: 23.10.2019 GB 201915377
(43) Date of publication of application: 31.08.2022
(73) Proprietor: SMART Photonics Holding B.V., 5656 AE Eindhoven (NL)
(72) Inventor: KLEIJN, Steven Everard Filippus, 5656 AE Eindhoven (NL); THIJS, Petrus Johannes Adrianus, 5656 AE Eindhoven (NL)
(74) Representative: EIP
(86) International application number: PCT/EP2020/079294
(87) International publication number: WO 2021/078657

(56) References cited:
- EP-A1- 1 729 167
- JP-A- H05 335 551
- US-A- 5 229 622
- US-A- 5 851 310

## Description

### Background

Quantum wells are commonly used in semiconductor structures to provide electronic confinement. For example, in optoelectronics devices, quantum wells are used to tune the electronic band gap, thereby tuning the energy (or frequency) of photons that are emitted (in the case of emitters) or absorbed (in the case of absorbers).

In many applications the effect of a quantum well can be increased by providing multiple quantum wells in a stack. In the case of an emitter, such as a laser, this may increase the rate of stimulated emission in the emitter, whereas in the case of an absorber, it may increase the rate of absorption.

A commonly commercially utilised material platform for optoelectronic devices is indium phosphide (InP), which allows for integration of optically active and passive functions into so-called photonic integrated circuits (PICs).

JP H05335551A relates to an optical semiconductor device. EP 1729167 A1 relates to a semiconductor optical modulator having a quantum well structure for increasing effective photocurrent generating capability.

It is desirable to provide a more reliable method of fabricating a semiconductor structure with multiple quantum wells.

### Brief Description of the Drawings

Figure 1 is a flow diagram illustrating a method of fabricating a semiconductor structure with multiple quantum wells, according to examples;
Figure 2 is a scanning electron micrograph of a semiconductor structure with multiple InP-containing quantum wells, showing defects in the resulting structure;
Figure 3 is a scanning electron micrograph of a semiconductor structure with multiple quantum wells not containing InP;
Figure 4 is a schematic diagram of a semiconductor structure, according to examples; and
Figure 5 is a scanning electron micrograph of a semiconductor structure with multiple InP-containing quantum wells, according to examples.

### Detailed Description

Examples described herein relate to methods of fabricating semiconductor structures. In particular, they relate to fabricating semiconductor structures with multiple quantum wells.

As will be elaborated below, examples described herein provide an improved semiconductor structure. Such a structure may provide reduced scattering of light being transmitted through the structure, may provide increased rates of stimulated emission in light emitting portions and may provide increased rates of absorption in light absorbing portions. This allows for a more efficient optoelectronic devices and therefore for a more efficient PIC.

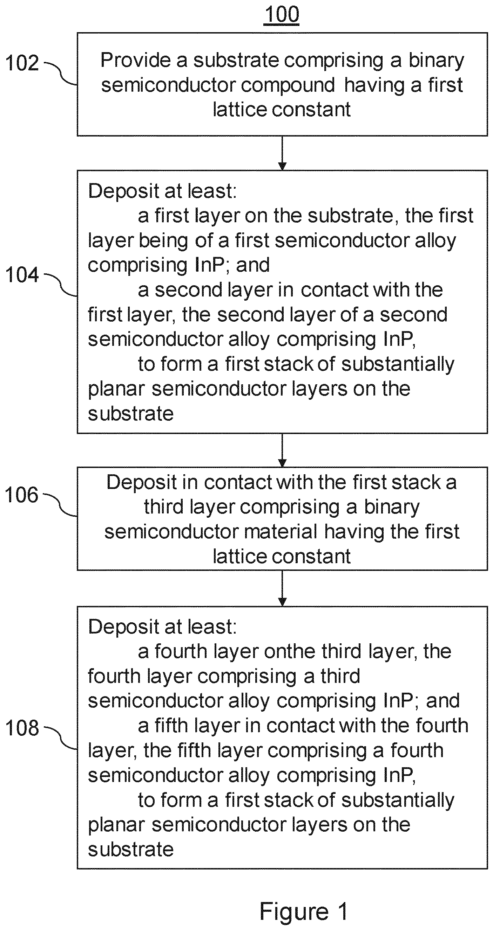

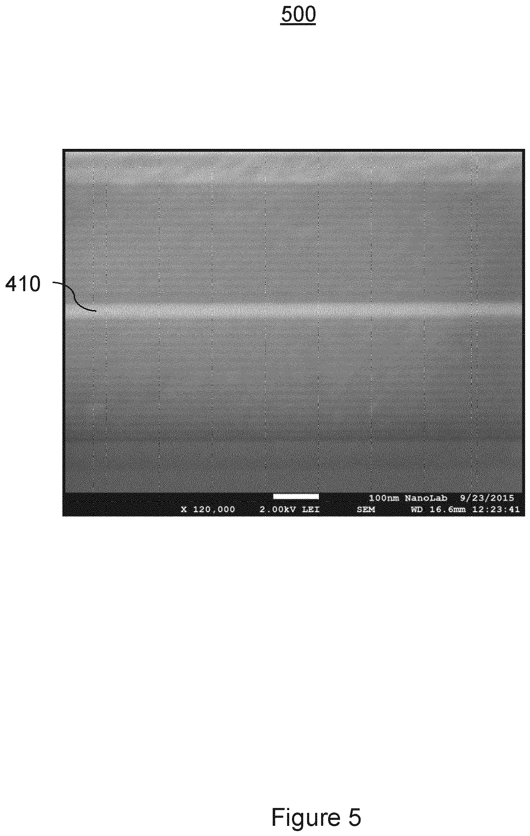

Figure 1 is a flow diagram illustrating, in a general manner, a method 100 of fabricating a semiconductor structure with multiple quantum wells, according to examples. A corresponding example semiconductor structure is described below with reference to Figure 5.

At block 102, a substrate is provided. The substrate comprises a binary semiconductor compound having a first lattice constant.

For example, the substrate may be an InP substrate. That is the substrate comprises mainly InP. The substrate 102 may be purely InP (within acceptable purity tolerances) or may comprise other materials such as dopants or impurities with the material comprising at least 99 % InP. For example, the substrate is doped with a dopant material so that the substrate may be considered n-doped or the substrate is doped with a dopant material so that the substrate may be considered p-doped.

At block 104, the method 100 comprises depositing, at least: a first layer on the substrate, and a second layer in contact with the first layer to form a first stack of substantially planar semiconductor layers on the substrate. The first layer is of a first semiconductor alloy comprising InP and the second layer is of a second semiconductor alloy comprising InP.

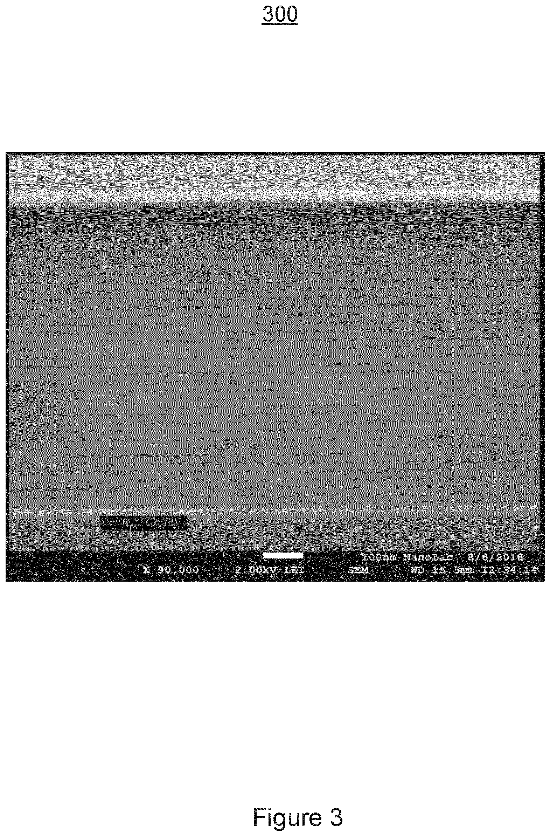

The first stack comprises a plurality of layers. A number of layers in the first stack is less than a threshold number of layers above which one or more layers of the stack would exhibit a defect. Fabrication of the first stack comprises depositing a number of layers of the first semiconductor alloy interspersed with a corresponding number of layers of the second semiconductor alloy. As described below with reference to Figure 3, at least in some examples, particularly examples in which the first and second layers comprise InP, there is an increasing tendency for defects to occur in the semiconductor layers of the first stack with an increasing number of semiconductor layers.

By saying that the layers are substantially planar, it is envisaged that the layers are for example deposited on the substrate such that the upper surface of each of the layers is parallel with the surface of the substrate on which the first layer is deposited.

In some examples, the first layer is on the substrate in the sense that it is deposited in contact with the substrate. In other examples, the first layer is on the substrate in that it is supported by the substrate but not directly in contact with the substrate. For example, there are one or more intermediate layers such as materials not comprising InP, such as indium aluminium arsenide (InAlAs).

As a general comment in relation to the term "on" used herein, a layer specified as being in contact with a layer (such as an underlying layer) is in direct contact with that layer; whereas, a layer specified as being on a layer (such as an underlying layer) may be in direct contact with that layer or may be supported by the layer, with one or more intermediate layers (such as of a material not comprising InP) therebetween.

In some examples, each of the layers is deposited substantially across the whole surface area of the substrate (e.g. except for areas of the substrate that are clamped by a wafer clamp of a reactor in which the semiconductor is being manufactured).

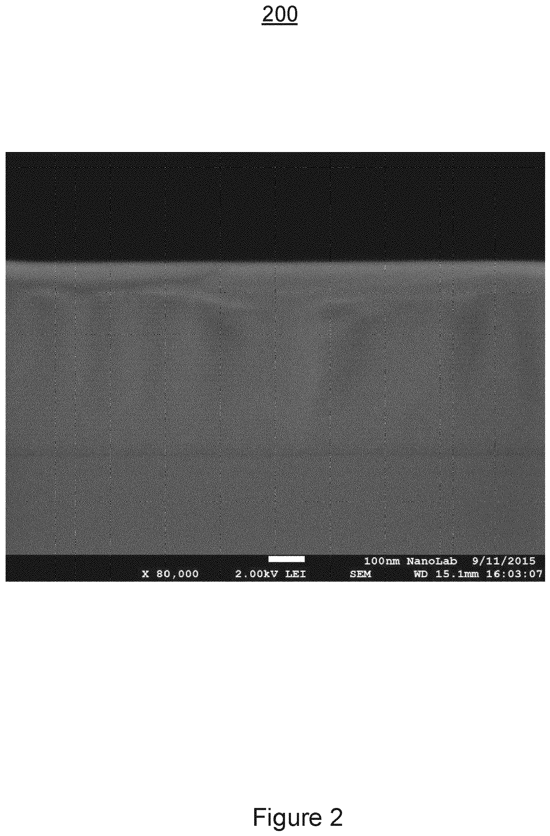

Figure 2 is scanning electron micrograph of a semiconductor structure comprising multiple quantum wells (32 in total) comprising InP; in this example, the quantum wells are formed of thin layers of indium gallium arsenide phosphide (InGaAsP), which are arranged to be unstrained by matching of the lattice constants to that of the substrate. As can be seen in Figure 2, growing many consecutive semiconductor quantum wells comprising InP leads to morphological defects in the layers of the semiconductor structure, which may, as described below, manifest as apparent non-planarity (e.g. undulations) in one or more layers of semiconductor. These defects can lead to failure of the epitaxial growth or to device failures in devices incorporating the semiconductor structure, which limits the number of quantum wells that can be grown in the structure.

As shown in Figure 2, the undulations manifest in the layers of the structure as viewed in cross-section. Theses undulations may not be present at the surface of the processed structure, which may still exhibit a planar surface; this may be due, for example, to the planarizing effects of an InP layer deposited on the layers of the semiconductor structure (for example, to form an electrical contact).

The inventors have therefore appreciated that, when fabricating multiple quantum wells using InP, a problem occurs which, as far as is known, does not appear when fabricating multiple quantum well using other semiconductor material platforms. The inventors determined that, depending on the processing conditions (e.g. pressure and temperature), defects were observed when more than approximately 16 quantum wells were grown in a stack.

The number of layers of each of the first and second semiconductor alloys is greater than 8 and fewer than 16, such that the total number of layers in the first stack is fewer than 32.

In contrast, Figure 3 is a scanning electron micrograph of a semiconductor structure comprising 36 quantum wells that do not include InP; in this example, the quantum wells are formed of indium aluminium gallium arsenide (InAlGaAs). As can be seen, the quantum wells shown in Figure 2 are substantially planar; this is despite there being many more quantum wells that can be fabricated using InP-containing quantum wells without forming defects such as those seen in Figure 2.

To address the problem described above with reference to Figure 2, at block 106, a third layer comprising a binary semiconductor material having the first lattice constant is deposited in contact with the first stack. For example, where the substrate is of InP, the third layer may also be of InP.

Then, at block 108, the method 100 comprises depositing, at least: a fourth layer in contact with the third layer and a fifth layer in contact with the fourth layer to form a second stack of substantially planar semiconductor layers on the third layer. The fourth layer comprises a third semiconductor alloy comprising InP and the fifth layer comprises a fourth semiconductor alloy comprising InP.

As the skilled person will appreciate, various techniques may be used to deposit the layers of semiconductor material in accordance with examples described herein. Such techniques may include chemical vapour deposition techniques such as metalorganic vapour-phase epitaxy (MOVPE) or molecular beam epitaxy (MBE).

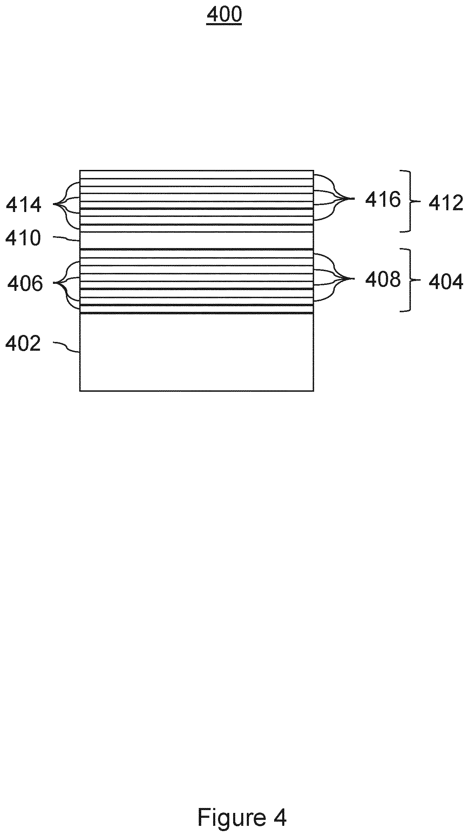

Figure 4 is a diagram of a semiconductor structure 400, according to examples. The semiconductor structure is fabricated according to the method described above with reference to Figure 1.

The semiconductor structure 400 comprises a substrate 402 onto which quantum wells are grown.

The semiconductor structure 400 includes a first stack 404 of quantum wells. The first stack 404 comprises multiple, alternating layers of a first semiconductor alloy 406 and a second semiconductor alloy 408. A first layer, of the first semiconductor alloy 406, is deposited on the substrate 402 and a second layer, of the second semiconductor alloy 408 is deposited in contact with the first layer of the first semiconductor alloy 406, as described above with reference to block 104 of Figure 1. Multiple quantum wells are fabricated by alternating between the deposition process for depositing the first semiconductor alloy 406 and the deposition process for depositing the second semiconductor alloy 408.

For the reasons described above, the first stack 404 comprises fewer than 32 layers. That is the first stack comprises fewer than 16 layers of the first semiconductor alloy 406 and fewer than 16 layers of the second semiconductor alloy 408.

In some examples, each of the first and second semiconductor alloys 406, 408 comprises a ternary semiconductor alloy or a quaternary semiconductor alloy. For example, each of the first and second semiconductor alloys 406, 408 comprises InGaAsP, wherein the relative amounts of indium phosphide (InP), gallium arsenide (GaAs), indium arsenide (InAs), and gallium phosphide (GaP) differ between the first and second semiconductor alloys 406, 408. Each of the first and second semiconductor alloys 406, 408 may be doped (e.g. p-doped or n-doped).

Although it is envisaged that each of the first and second semiconductor alloys 406, 408 is unstrained (e.g. that the lattice constant of one layer is matched to the layers in which that layer is in contact) in some examples it is desirable to select lattice constants that introduce strain to, for example, modify the optical absorption or emission properties of the semiconductor structure 400.

In some examples, the layers of each of the first and second semiconductor alloys 406, 408 are less than 15 nanometers (nm).

Deposited in contact with the first stack 404 is a third layer 410. The third layer 410 is a binary semiconductor having a lattice constant substantially equal to a lattice constant of the substrate 402, as described above with reference to block 106 of Figure 1. By substantially equal it is meant that no strain is intended to be induced by the introduction of the third layer 410.

The thickness of the third layer 410 may be in the range 4 nm to 100 nm.

Inclusion of a third semiconductor layer 410 having a lattice constant that is substantially equal to that of the substrate 402 means that the fabrication process (e.g. the method of Figure 2) may be performed without modification of the fabrication reactor or any modification of process conditions of the reactor, such as temperature or pressure, prior to fabrication of the third layer 410. This may, in examples, provide for easy integration into existing fabrication processes.

Furthermore, adding only a single, thin layer of binary semiconductor material presents a negligible effect on the overall electro-optical properties of the semiconductor structure 400 and so performance of devices incorporating the semiconductor structure 400 is not adversely affected by the inclusion of the third layer 410.

Deposited in contact with the third layer 410, is a second stack 412 of quantum wells. The second stack 412 comprises multiple, alternating layers of a third semiconductor alloy 414 and a fourth semiconductor alloy 416. A layer of the third semiconductor alloy 414, is deposited on the third layer 410 and a layer of the fourth semiconductor alloy 416 is deposited on the layer of the third semiconductor alloy 414 deposited in contact with the third layer 410, as described above with reference to block 108. Multiple quantum wells are fabricated by alternating between the deposition process for depositing the third semiconductor alloy 414 and the deposition process for depositing the fourth semiconductor alloy 416.

The second stack 412 also comprises fewer than 32 layers. The first stack comprises fewer than 16 layers of the first semiconductor alloy 406 and fewer than 16 layers of the second semiconductor alloy 408.

In some examples, each of the third and fourth semiconductor alloys 414, 416 comprises a ternary semiconductor alloy or a quaternary semiconductor alloy. For example, each of the third and fourth semiconductor alloys 414, 416 comprises InGaAsP, wherein the relative amounts of indium phosphide (InP), gallium arsenide (GaAs), indium arsenide (InAs), and gallium phosphide (GaP) differ between the third and fourth semiconductor alloys (414,416). Each of the third and fourth semiconductor alloys 414, 416 may be doped (e.g. p-doped or n-doped).

Although it is envisaged that each of the third and fourth semiconductor alloys 414,416 is unstrained (e.g. that the lattice constants of one layer is matched to the adjacent layers) in some examples it may be desirable to select lattice constants that introduce strain to, for example, modify the optical absorption or emission properties of the semiconductor structure 400.

In some examples, the processes described with reference to blocks 106 and 108 of Figure 1 may be repeated to further increase the number of quantum wells in the semiconductor structure 400.

Although in the example shown in Figure 4, the first stack 404 and the second stack 412 have equal numbers of layer so that the third layer 410 is in the centre of the overall stack, in other examples, the first stack 404 has a different number of quantum well layers to the second stack 412. That is the third layer 410 may be elsewhere within the semiconductor structure 400, not necessarily in the exact middle of the layers of quantum wells. For example, in a semiconductor structure 400 comprising 25 quantum wells layers, the third layer 410 may be deposited after 9 quantum wells have been fabricated and 16 quantum wells may be fabricated above the third layer 410.

Figure 5 is a scanning is a scanning electron micrograph of a semiconductor structure comprising 24 quantum wells comprising InP; in this example, the quantum wells are formed of thin layers of indium gallium arsenide phosphide (InGaAsP), which are arranged to be unstrained by matching of the lattice constants to that of the substrate. The third layer 410 described above is identifiable as a bright band approximately in the centre of a stack of darker bands (which correspond to quantum well structures. As can be seen in Figure 2, introduction of the third layer 410, which is a single thin layer of a material enables a significant increase in the number of InP-containing quantum well layers that can be fabricated in a semiconductor structure before defects such as those shown in Figure 2 become present. Accordingly, the method described above with reference to Figure 1 provides a simple and efficient way to allow the growth of thicker stacks of quantum wells containing InP.

Increasing the total thickness of a stack of repeating epitaxial quantum well layers can be useful by, for example, increasing optical confinement in the semiconductor. For example, a more efficient electro-absorption or electro-refractive modulator can be produced, because the efficiency of electro-absorption and electro-refractive modulators is related to optical confinement.

The above examples are to be understood as illustrative examples.

## Claims

1. A method of fabricating a semiconductor structure (400) with multiple quantum wells, the method comprising:
providing (102) a substrate (402) comprising a binary semiconductor compound having a first lattice constant;
forming, on the substrate (402), a first stack (404) of quantum wells comprising substantially planar semiconductor layers comprising greater than 8 and fewer than 16 layers (406) of a first semiconductor alloy comprising InP, and greater than 8 and fewer than 16 layers (408) of a second semiconductor alloy comprising InP, by depositing (104) at least:
a first layer on the substrate (402), the first layer of the first semiconductor alloy comprising InP, and
a second layer in contact with the first layer, the second layer of the second semiconductor alloy comprising InP;
depositing (106), in contact with the first stack (404), a third layer (410) of a binary semiconductor compound having substantially the first lattice constant of the substrate (402);
depositing (108) at least:
a fourth layer (414) on the third layer (410), the fourth layer comprising a third semiconductor alloy comprising InP, and
a fifth layer (416) in contact with the fourth layer (414), the fifth layer (416) comprising a fourth semiconductor alloy comprising InP, to form a second stack (412) of quantum wells comprising of substantially planar semiconductor layers on the third layer (410).

2. A semiconductor structure (400) with multiple quantum wells, the semiconductor structure (400) comprising:
a substrate (402) comprising a binary semiconductor compound having a first lattice constant;
a first stack (404) of quantum wells comprising substantially planar semiconductor layers on the substrate (402), the first stack (404) comprising:
greater than 8 and fewer than 16 layers (406) of a first semiconductor alloy comprising InP, the layers (406) of the first semiconductor alloy comprising a first layer on the substrate (402), and
greater than 8 and fewer than 16 layers (408) of a second semiconductor alloy comprising InP, the layers (408) of the second semiconductor alloy comprising a second layer in contact with the first layer;
a third layer (410) in contact with the first stack (404), the third layer (410) of a binary semiconductor compound having substantially the first lattice constant of the substrate (402); and
a second stack (412) of quantum wells comprising substantially planar semiconductor layers on the third layer (410), the second stack (412) comprising at least:
a fourth layer (414) on the third layer (410), the fourth layer comprising a third semiconductor alloy comprising InP, and
a fifth layer (416) in contact with the fourth layer (414), the fifth layer (416) comprising a fourth semiconductor alloy comprising InP.

3. The method or semiconductor structure (400) of any preceding claim, wherein at least one of:
the third semiconductor alloy is substantially the same as the first semiconductor alloy, or
the fourth semiconductor alloy is substantially the same as the second semiconductor alloy.

4. The method or semiconductor structure (400) of any preceding claim, wherein each of the first, second, third and fourth semiconductor alloys is, respectively, one of a ternary semiconductor alloy or a quaternary semiconductor alloy.

5. The method or semiconductor structure (400) of any preceding claim, wherein each of the first, second, third and fourth semiconductor alloys is of InGaAsP, wherein relative amounts of InP, GaAs, InAs, and GaP differ between the first and second semiconductor alloys and between the third and fourth semiconductor alloys.

6. The method or semiconductor structure (400) of any preceding claim, wherein the number of layers in the second stack (412) is equal to the number of layers in the first stack (404).

7. The method or semiconductor structure (400) of any preceding claim, wherein the third layer (410) and/or the substrate (402) is of InP.

8. The method or semiconductor structure (400) of any preceding claim, wherein a thickness of the third layer (410) is greater than 4 nm and/or less than 100 nm.

9. The method or semiconductor structure (400) of any preceding claim, wherein the first layer is in contact with the substrate (402).

10. An electro-absorption modulator or an electro-refractive modulator comprising the semiconductor structure (400) of any of claims 2 to 9.

## Patentansprüche

1. Verfahren zum Herstellen einer Halbleiterstruktur (400) mit mehreren Quantentöpfen, wobei das Verfahren umfasst:
Bereitstellen (102) eines Substrats (402), umfassend eine binäre Halbleiterverbindung, die eine erste Gitterkonstante aufweist;
Ausbilden eines ersten Stapels (404) von Quantentöpfen auf dem Substrat (402), umfassend im Wesentlichen planare Halbleiterschichten, umfassend mehr als 8 und weniger als 16 Schichten (406) einer ersten Halbleiterlegierung, umfassend InP, und mehr als 8 und weniger als 16 Schichten (408) einer zweiten Halbleiterlegierung, umfassend InP, durch Abscheiden (104) von mindestens:
einer ersten Schicht auf dem Substrat (402), wobei die erste Schicht der ersten Halbleiterlegierung InP umfasst und
einer zweiten Schicht in Kontakt mit der ersten Schicht, wobei die zweite Schicht der zweiten Halbleiterlegierung InP umfasst;
Abscheiden (106), in Kontakt mit dem ersten Stapel (404), einer dritten Schicht (410) einer binären Halbleiterverbindung, die im Wesentlichen die erste Gitterkonstante des Substrats (402) aufweist;
Abscheiden (108) von mindestens:
einer vierten Schicht (414) auf der dritten Schicht (410), wobei die vierte Schicht eine dritte Halbleiterlegierung umfasst, umfassend InP, und
einer fünften Schicht (416) in Kontakt mit der vierten Schicht (414), wobei die fünfte Schicht (416) eine vierte Halbleiterlegierung umfasst, umfassend InP,
um einen zweiten Stapel (412) von Quantentöpfen, umfassend im Wesentlichen planare Halbleiterschichten, auf der dritten Schicht (410) auszubilden.

2. Halbleiterstruktur (400) mit mehreren Quantentöpfen, wobei die Halbleiterstruktur (400) umfasst:
ein Substrat (402), umfassend eine binäre Halbleiterverbindung, die eine erste Gitterkonstante aufweist;
einen ersten Stapel (404) von Quantentöpfen, umfassend im Wesentlichen planare Halbleiterschichten auf dem Substrat (402), wobei der erste Stapel (404) umfasst:
mehr als 8 und weniger als 16 Schichten (406) einer ersten Halbleiterlegierung, umfassend InP, wobei die Schichten (406) der ersten Halbleiterlegierung eine erste Schicht auf dem Substrat (402) umfassen, und
mehr als 8 und weniger als 16 Schichten (408) einer zweiten Halbleiterlegierung, umfassend InP, wobei die Schichten (408) der zweiten Halbleiterlegierung eine zweite Schicht in Kontakt mit der ersten Schicht umfassen;
eine dritte Schicht (410) in Kontakt mit dem ersten Stapel (404), wobei die dritte Schicht (410) einer binären Halbleiterverbindung im Wesentlichen die erste Gitterkonstante des Substrats (402) aufweist; und
einen zweiten Stapel (412) von Quantentöpfen, umfassend im Wesentlichen planare Halbleiterschichten auf der dritten Schicht (410), wobei der zweite Stapel (412) mindestens umfasst:
eine vierten Schicht (414) auf der dritten Schicht (410), wobei die vierte Schicht eine dritte Halbleiterlegierung umfasst, umfassend InP, und
eine fünfte Schicht (416) in Kontakt mit der vierten Schicht (414), wobei die fünfte Schicht (416) eine vierte Halbleiterlegierung umfasst, umfassend InP.

3. Verfahren oder Halbleiterstruktur (400) nach einem der vorstehenden Ansprüche, wobei mindestens eines gilt:
die dritte Halbleiterlegierung ist im Wesentlichen die gleiche wie die erste Halbleiterlegierung oder
die vierte Halbleiterlegierung ist im Wesentlichen die gleiche wie die zweite Halbleiterlegierung.

4. Verfahren oder Halbleiterstruktur (400) nach einem der vorstehenden Ansprüche, wobei jede der ersten, der zweiten, der dritten und der vierten Halbleiterlegierung jeweils eine von einer ternären Halbleiterlegierung oder einer quaternären Halbleiterlegierung ist.

5. Verfahren oder Halbleiterstruktur (400) nach einem der vorstehenden Ansprüche, wobei jede der ersten, der zweiten, der dritten und der vierten Halbleiterlegierung aus InGaAsP besteht, wobei relative Mengen von InP, GaAs, InAs und GaP zwischen der ersten und der zweiten Halbleiterlegierung und zwischen der dritten und der vierten Halbleiterlegierung unterschiedlich sind.

6. Verfahren oder Halbleiterstruktur (400) nach einem der vorstehenden Ansprüche, wobei die Anzahl der Schichten in dem zweiten Stapel (412) gleich der Anzahl der Schichten in dem ersten Stapel (404) ist.

7. Verfahren oder Halbleiterstruktur (400) nach einem der vorstehenden Ansprüche, wobei die dritte Schicht (410) und/oder das Substrat (402) aus InP besteht.

8. Verfahren oder Halbleiterstruktur (400) nach einem der vorstehenden Ansprüche, wobei eine Dicke der dritten Schicht (410) größer als 4 nm und/oder kleiner als 100 nm ist.

9. Verfahren oder Halbleiterstruktur (400) nach einem der vorstehenden Ansprüche, wobei die erste Schicht mit dem Substrat (402) in Kontakt steht.

10. Elektroabsorptionsmodulator oder elektrorefraktiver Modulator, umfassend die Halbleiterstruktur (400) nach einem der Ansprüche 2 bis 9.

## Revendications

1. Procédé de fabrication d'une structure semi-conductrice (400) à puits quantiques multiples, le procédé comprenant :
la fourniture (102) d'un substrat (402) comprenant un composé semi-conducteur binaire ayant une première constante de réseau ;
la formation, sur le substrat (402), d'un premier empilement (404) de puits quantiques comprenant des couches semi-conductrices sensiblement planes comprenant plus de 8 et moins de 16 couches (406) d'un premier alliage semi-conducteur comprenant de l'InP, et plus de 8 et moins de 16 couches (408) d'un deuxième alliage semi-conducteur comprenant de l'InP, par dépôt (104) d'au moins :
une première couche sur le substrat (402), la première couche du premier alliage semi-conducteur comprenant de l'InP, et
une deuxième couche en contact avec la première couche, la deuxième couche du deuxième alliage semi-conducteur comprenant de l'InP ;
le dépôt (106), en contact avec le premier empilement (404), d'une troisième couche (410) d'un composé semi-conducteur binaire ayant sensiblement la première constante de réseau du substrat (402) ;
le dépôt (108) d'au moins :
une quatrième couche (414) sur la troisième couche (410), la quatrième couche comprenant un troisième alliage semi-conducteur comprenant de l'InP, et
une cinquième couche (416) en contact avec la quatrième couche (414), la cinquième couche (416) comprenant un quatrième alliage semi-conducteur comprenant de l'InP,
pour former un second empilement (412) de puits quantiques comprenant des couches semi-conductrices sensiblement planes sur la troisième couche (410).

2. Structure semi-conductrice (400) à puits quantiques multiples, la structure semi-conductrice (400) comprenant :
un substrat (402) comprenant un composé semi-conducteur binaire ayant une première constante de réseau ;
un premier empilement (404) de puits quantiques comprenant des couches semi-conductrices sensiblement planes sur le substrat (402), le premier empilement (404) comprenant :
plus de 8 et moins de 16 couches (406) d'un premier alliage semi-conducteur comprenant de l'InP, les couches (406) du premier alliage semi-conducteur comprenant une première couche sur le substrat (402), et
plus de 8 et moins de 16 couches (408) d'un deuxième alliage semi-conducteur comprenant de l'InP, les couches (408) du deuxième alliage semi-conducteur comprenant une deuxième couche en contact avec la première couche ;
une troisième couche (410) en contact avec le premier empilement (404), la troisième couche (410) d'un composé semi-conducteur binaire ayant sensiblement la première constante de réseau du substrat (402) ; et
un second empilement (412) de puits quantiques comprenant des couches semi-conductrices sensiblement planes sur la troisième couche (410), le second empilement (412) comprenant au moins :
une quatrième couche (414) sur la troisième couche (410), la quatrième couche comprenant un troisième alliage semi-conducteur comprenant de l'InP, et
une cinquième couche (416) en contact avec la quatrième couche (414), la cinquième couche (416) comprenant un quatrième alliage semi-conducteur comprenant de l'InP.

3. Procédé ou structure semi-conductrice (400) selon l'une quelconque revendication précédente, dans lequel au moins l'un parmi :
le troisième alliage semi-conducteur est sensiblement le même que le premier alliage semi-conducteur, ou
le quatrième alliage semi-conducteur est sensiblement le même que le deuxième alliage semi-conducteur.

4. Procédé ou structure semi-conductrice (400) selon l'une quelconque revendication précédente, dans lequel chacun des premier, deuxième, troisième et quatrième alliages semi-conducteurs est, respectivement, un alliage semi-conducteur ternaire ou un alliage semi-conducteur quaternaire.

5. Procédé ou structure semi-conductrice (400) selon l'une quelconque revendication précédente, dans lequel chacun des premier, deuxième, troisième et quatrième alliages semi-conducteurs est InGaAsP, dans lequel les quantités relatives d'InP, du GaAs, de l'InAs, et du GaP, diffèrent entre les premier et deuxième alliages semi-conducteurs et entre les troisième et quatrième alliages semi-conducteurs.

6. Procédé ou structure semi-conductrice (400) selon l'une quelconque revendication précédente, dans lequel le nombre de couches dans le second empilement (412) est égal au nombre de couches dans le premier empilement (404).

7. Procédé ou structure semi-conductrice (400) selon l'une quelconque revendication précédente, dans lequel la troisième couche (410) et/ou le substrat (402) est en InP.

8. Procédé ou structure semi-conductrice (400) selon l'une quelconque revendication précédente, dans lequel une épaisseur de la troisième couche (410) est supérieure à 4 nm et/ou inférieure à 100 nm.

9. Procédé ou structure semi-conductrice (400) selon l'une quelconque revendication précédente, dans lequel la première couche est en contact avec le substrat (402).

10. Modulateur à électro-absorption ou modulateur à électro-réfraction comprenant la structure semi-conductrice (400) selon l'une quelconque des revendications 2 à 9.
